# EUROPEAN PATENT SPECIFICATION

(11) **EP 4 513 567 B1**
(45) Date of publication and mention of the grant of the patent: **13.08.2025**
(21) Application number: 23192336.8
(22) Date of filing: 21.08.2023
(51) Int. Cl.: H10D 12/00, H10D 30/66, H10D 62/832, H10D 64/68, H10D 12/01, H01L 21/04

(54) **METHOD FOR PRODUCING A SILICON CARBIDE SEMICONDUCTOR DEVICE AND SEMICONDUCTOR DEVICE**
VERFAHREN ZUR HERSTELLUNG EINES SILIZIUMKARBID HALBLEITERBAUELEMENTS UND HALBLEITERBAUELEMENT
PROCÉDÉ DE FABRICATION D'UN DISPOSITIF SEMI-CONDUCTEUR EN CARBURE DE SILICIUM ET DISPOSITIF SEMI-CONDUCTEUR

(43) Date of publication of application: 26.02.2025
(73) Proprietor: Hitachi Energy Ltd, 8050 Zürich (CH)
(72) Inventor: BOLAT, Sami, 5630 Muri (CH); KLIPFEL, Nadja, 5702 Niederlenz (CH); ARANGO, Yulieth Cristina, 8045 Zürich (CH); WEHRLE, Moritz, 8304 Wallisellen (CH); ROMANO, Gianpaolo, 5400 Baden (CH); ALFIERI, Giovanni, 5103 Möriken (CH); MIHAILA, Andrei, 5415 Rieden (CH)
(74) Representative: Epping - Hermann - Fischer

(56) References cited:
- US-A1- 2012 223 338
- US-A1- 2019 267 451
- US-A1- 2019 296 146
- US-A1- 2020 091 297
- US-A1- 2020 220 001

## Description

The present disclosure relates to a method for producing a semiconductor device.

Document US 2019/0296146 A1 relates to a semiconductor device including a silicon carbide layer, a gate electrode, a gate insulating layer disposed between the silicon carbide layer and the gate electrode, a first region disposed in the silicon carbide layer and containing nitrogen, and a second region disposed between the first region and the gate insulating layer, and containing at least one element selected from the group consisting of nitrogen, phosphorus, arsenic, antimony, scandium, yttrium, lanthanum, lanthanoids, hydrogen, deuterium, and fluorine.

Document US 2020/0220001 A1 relates to a semiconductor device including a silicon carbide layer having a first and a second planes, a first electrode located on a side of the first plane, a second electrode located on a side of the second plane, a gate electrode, an aluminum nitride layer containing an aluminum nitride crystal between the second silicon carbide region and the gate electrode, and an insulating layer between the aluminum nitride layer and the gate electrode and having a wider band gap than the aluminum nitride layer.

Document US 2012/0223338 A1 relates to a method of manufacturing a semiconductor device including the steps of forming a silicon oxynitride film on a silicon carbide substrate, forming a silicon oxide film on the silicon oxynitride film, annealing the silicon carbide substrate, the silicon oxynitride film and the silicon oxide film, wherein the silicon oxide film is exposed to a gas containing hydrogen, and forming an aluminum oxynitride film on the silicon oxide film after the annealing.

Document US 2020/0091297 A1 relates to a semiconductor device including a silicon carbide layer, a gate electrode, a gate insulating layer provided between the silicon carbide layer and the gate electrode, and a region located between the silicon carbide layer and the gate insulating layer, the region having a first bonding structure, the first bonding structure including a threefold coordinated first nitrogen atom bonded to three first silicon atoms, a threefold coordinated second nitrogen atom bonded to three second silicon atoms, and a threefold coordinated third nitrogen atom bonded to three third silicon atoms, the first to third nitrogen atoms being adjacent to each other in the first bonding structure.

One object to be achieved is to provide a method for producing a semiconductor device with the help of which the flat band voltage (V_{FB}) can be engineered. V_{FB} influences Vₜₕ and this in turn influences the device performance. A further object to be achieved is to provide a semiconductor device with an engineered flat band voltage, thereby having a proper threshold voltage in order to enhance the device's blocking and on-state performance.

This object is achieved by a method as defined in claim 1. Exemplary further developments constitute the subject-matter of the dependent claims.

The method for producing the semiconductor device comprises a step of providing a semiconductor body of SiC. In a further step, a nitride-based dielectric layer is applied on this surface. Then, the dielectric layer is annealed in an atmosphere which contains hydrogen.

Conventional SiC semiconductor devices, like SiC MOSFETs or SiC IGBTs, usually have SiO₂ as the dielectric layer. Due to the defective interface between the dielectric layer and the SiC, such devices suffer from limited mobility values causing high R_{ON} values. To minimize the defect density at the interfaces SiO₂ can be annealed in NO or N₂O ambient to improve the interface with the SiC. However, this treatment yields limited improvements in terms of mobility.

To decrease the R_{ON}, it is also possible to implement high-k insulators, e.g. as gate dielectrics. Such materials offer higher dielectric capacitance values leading to lower R_{ON} values with process optimization compared to their SiO₂ counterparts. However, these materials suffer from undesirably high V_{FB} shifts (towards negative or positive values) when integrated into SiC semiconductor devices and annealed in inert atmospheres.

Indeed, annealing of nitride-based dielectric materials in inert atmospheres (mainly N₂) at high temperature (>1000°C) creates nitrogen vacancies in the dielectric layer. These defects are responsible for deep-level trap creation in the material, shifting V_{FB} to undesirably high (positive or negative) voltage levels. In the current invention, this problem is solved by hydrogen-based annealing of the nitride-based dielectric layer after its deposition. Reintroducing hydrogen into the dielectric layer replaces the nitrogen vacancies. It converts the deep traps into shallow ones, resulting in several volts, e.g. ~3V, reduction of the V_{FB} which, in a MOSFET or IGBT, translates into less negative/positive V_{TH} characteristics.

The semiconductor body of the semiconductor device comprises SiC, e.g. 4H-SiC or 3C-SiC. For example, the semiconductor body comprises a substrate on which SiC is epitaxially grown. The substrate may be of Si, SiO₂ or SiC. At least a portion of the semiconductor body, e.g. the SiC thereof, may be doped, for example n-doped.

The whole surface of the semiconductor body is formed of SiC, i.e. SiC is exposed at a surface of the semiconductor body. For example, the SiC of the surface is located at a top side of the semiconductor body or in a trench formed in the semiconductor body. The exposed SiC may be epitaxially grown SiC.

The nitride-based dielectric layer is applied onto the surface which is of SiC. The nitride-based dielectric layer is applied directly onto the exposed SiC such that it adjoins the SiC of the semiconductor body. An interface is then formed between the nitride-based dielectric layer and the semiconductor body at which SiC and the nitride-based dielectric material are in direct contact with each other.

In particular, the dielectric layer is or forms at least a part of a gate dielectric, i.e. the dielectric layer electrically insulates a gate electrode from the semiconductor body.

The nitride-based dielectric layer is, in particular, a high k dielectric layer. For example, the nitride-based dielectric layer is applied with a layer thickness between 10 nm and 1 µm, preferably between 20 nm and 200 nm.

After application of the dielectric layer, the dielectric layer is annealed in an atmosphere which contains hydrogen. In this step, hydrogen molecules come into contact with the dielectric layer and hydrogen atoms can diffuse into the dielectric layer. For example, annealing of the dielectric layer is only performed in the atmosphere containing hydrogen. Particularly, no annealing in a hydrogen-free atmosphere is performed before annealing in the atmosphere containing hydrogen.

The atmosphere in which the dielectric layer is annealed consists of nitrogen and hydrogen. For example, at least 99 at-% or at least 99.9 at-% of the atmosphere is formed by nitrogen (N2) and hydrogen (H2). at-% is herein used as the abbreviation of atomic percentage.

The concentration of hydrogen in the atmosphere, in which the dielectric layer is annealed, is at least 1 at-% or at least 2 at-%. Additionally, the concentration is at most 10 at-% or at most 6 at-%. For example, the concentration is 4 at-%.

The dielectric layer is annealed at a temperature of least 1000°C.

The dielectric layer is annealed at atmospheric pressure ± 20% or at atmospheric pressure ± 10%. That is, the pressure at which the dielectric layer is annealed is in the range between 811 mbar and 1216 mbar, particularly in the range between 912 mbar and 1115 mbar. The borders are included.

The dielectric layer is annealed for at least ten minutes or at least half an hour or at least one hour in the atmosphere containing hydrogen.

The dielectric layer
consists of at least one of: silicon nitride (Si₃N₄), silicon oxynitride (Si₂N₂O). For example, the dielectric layer consists of silicon nitride or of silicon oxynitride.

According to a further embodiment, the method comprises a further step of cleaning the surface which is at least partially formed of SiC. This step is performed before applying the dielectric layer. The surface is cleaned, for example, in a wet cleaning process.

According to a further embodiment, the method further comprises a step of applying an electrically conductive layer onto the dielectric layer after annealing of the dielectric layer. For example, the electrically conductive layer is formed of metal or highly-doped polysilicon. The electrically conductive layer is, for example, a gate electrode of the semiconductor device. The electrically conductive layer may be applied directly onto the dielectric layer so that the electrically conductive material of the electrically conductive layer adjoins the nitride-based dielectric material of the dielectric layer.

The dielectric layer is, in particular, applied directly onto the semiconductor body. For example, the semiconductor material of the semiconductor body adjoining the dielectric layer is at least partially, particularly completely, formed of SiC. This means that there can be an interface at which SiC adjoins the nitride-based dielectric layer.

According to a further embodiment, the concentration of hydrogen in the dielectric layer is at least 0.1 at-% or at least 0.5 at-% or at least 1 at-%.

According to a further embodiment, the semiconductor device is a power semiconductor device.

According to a further embodiment, the semiconductor device is an insulated gate device, particularly a transistor with an insulated gate electrode. Particularly, the dielectric layer serves as an insulation between a gate electrode and the semiconductor body. In other words, the dielectric layer forms at least a part of the gate dielectric.

According to a further embodiment, the semiconductor device is a MISFET or MOSFET or an IGBT or a JFET. The IGBT can be a normal IGBT or an RC IGBT.

Hereinafter, the method for producing a semiconductor device will be explained in more detail with reference to the drawings on the basis of exemplary embodiments. The accompanying figures are included to provide a further understanding. In the figures, elements of the same structure and/or functionality may be referenced by the same reference signs. It is to be understood that the embodiments shown in the figures are illustrative representations and are not necessarily drawn to scale. Insofar as elements or components correspond to one another in terms of their function in different figures, the description thereof is not repeated for each of the following figures. For the sake of clarity, elements might not appear with corresponding reference symbols in all figures.
Figures 1 to 6 show different positions in an exemplary embodiment of the method for producing a semiconductor device,
Figure 7 and 8 show different exemplary embodiments of the produced semiconductor device,
Figures 9 and 10 show different measurements,
Figure 11 shows a further exemplary embodiment of the semiconductor device.

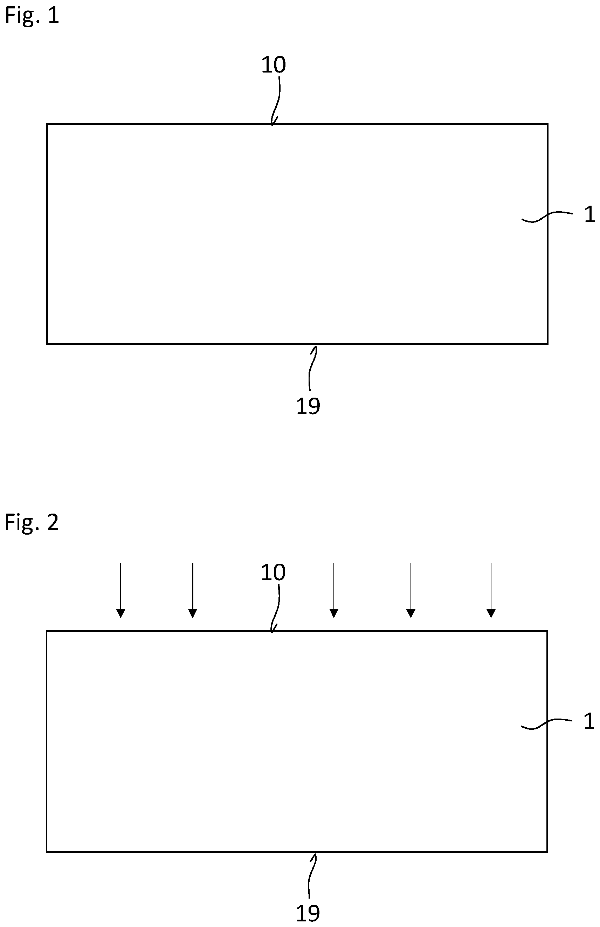

Figure 1 shows a first position in an exemplary embodiment of the method for producing a semiconductor device. A semiconductor body 1 is provided with a top side 10 and a bottom side 19, opposite to the top side 10. The top side 10 is formed of SiC. The semiconductor body 1 completely consists of SiC. Particularly, the semiconductor body 1 of figure 1 consists of n-doped semiconductor material.

Figure 2 shows a position in which the top side 10 of the semiconductor body 1 is cleaned.

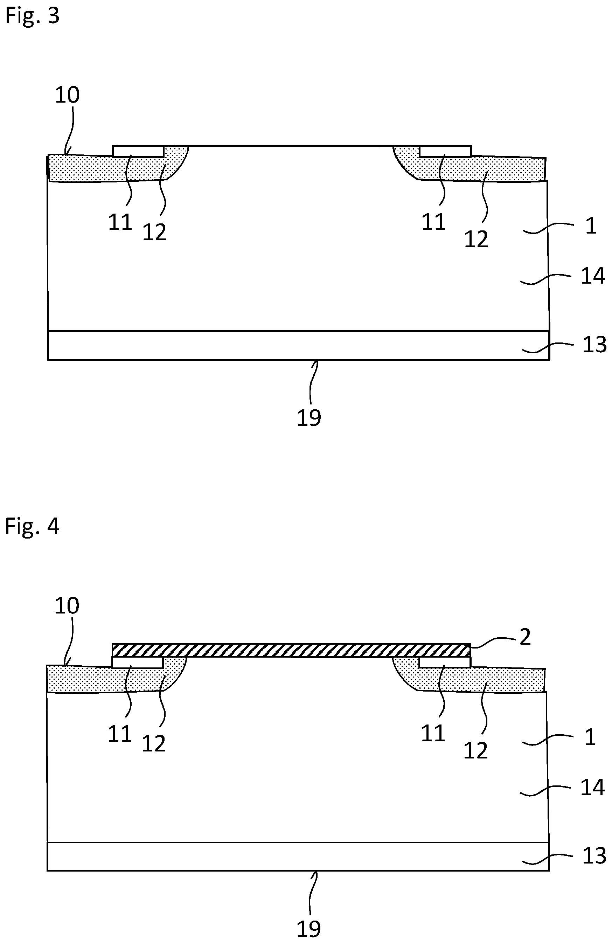

In the position of figure 3, the semiconductor body 1 has been further processed. Particularly, p-doped base regions 12 have been formed inside the semiconductor body 1, e.g. with the help of ion implantation. Furthermore, n-doped contact regions 11 have been formed, e.g. also with the help of ion implantation. The n-doped contact regions 11 are separated and spaced from a drift region 14 of the semiconductor body 1 by the base regions 12. The drift region 14 is also n-doped.

An n-doped contact layer 13 has been formed at the bottom side 19 of the semiconductor body 1.

Figure 4 shows a position in which a dielectric layer 2 is deposited directly onto the top side 10 of the semiconductor body 1. The dielectric layer 2 is a high k nitride-based dielectric layer. The dielectric layer 2 consists, for example, of Si₃N₄. The dielectric layer 2 may have been applied by vacuum deposition. Thereby, an interface is formed between the semiconductor body 1 and the dielectric layer 2, at which the SiC and the nitride-based dielectric material adjoin each other.

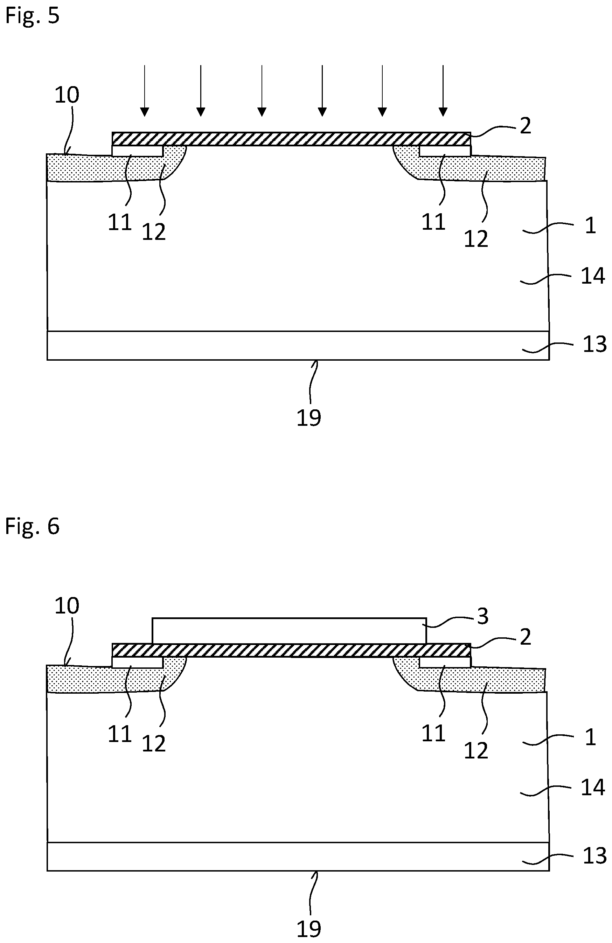

Figure 5 shows a position in which the dielectric layer 2 is annealed in an atmosphere which contains hydrogen. The dielectric layer 2 is annealed at a temperature of at least 1000°C and at atmospheric pressure. The atmosphere only comprises hydrogen and nitrogen and the concentration of hydrogen in the atmosphere is about 4 at-%. Annealing of the dielectric layer 2 may be done for at least half an hour, for example. During the annealing, nitrogen vacancies are formed. These nitrogen vacancies are at least partially filled with hydrogen atoms.

Figure 6 shows a position after annealing of the dielectric layer 2 and after application of an electrically conductive layer 3 in the form of a gate electrode 3 onto the dielectric layer 2. The gate electrode 3 is, for example, formed of highly-doped polysilicon. The dielectric layer 2 forms the gate dielectric.

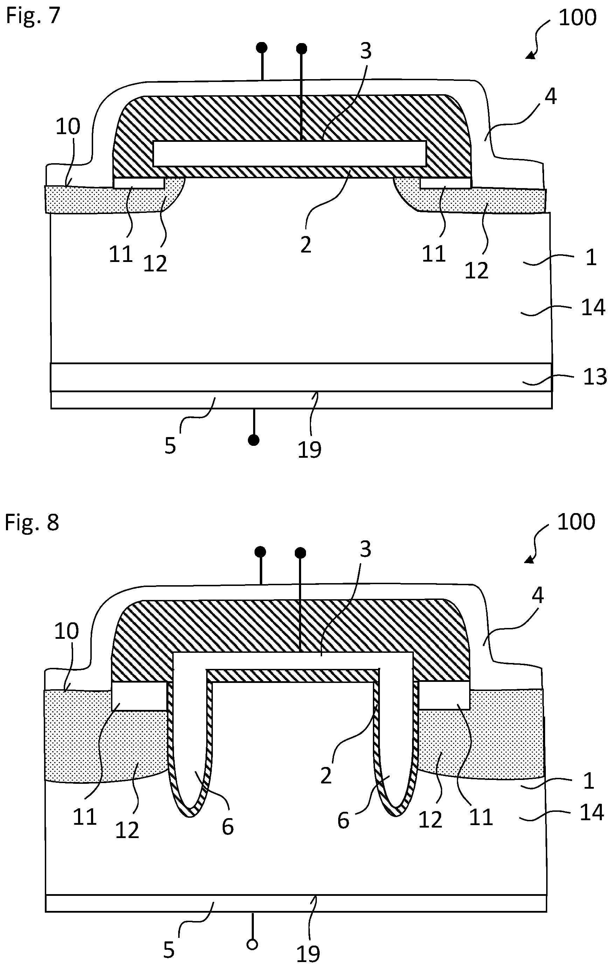

Figure 7 shows a position after finalizing of the semiconductor device 100. The semiconductor device 100 is, in this case, MOSFET or MISFET, respectively. For finalizing the semiconductor device 100, the gate electrode 3 has further been covered by dielectric material and main electrodes 4, 5 have been applied onto the top side 10 and the bottom side 19. The first main electrode 4 electrically contacts the contact regions 11 and the second main electrode 5 electrically contacts the contact layer 13. The IGBT of figure 7 is of planar design or planar gate design, respectively.

Figure 8 shows a further exemplary embodiment of the semiconductor device 100 which is produced with the method described herein. In this case, the semiconductor device 100 is a MOSFET or MISFET, respectively, of a trench design or trench gate design, respectively. Here, the gate electrode 3 is arranged in trenches 6 which extend from the top side 10 into the semiconductor body 1. The gate electrode 3 inside the trenches 6 is electrically insulated from the semiconductor body 1 by the nitride-based dielectric layer 2. The semiconductor body 1 may again consist of SiC. The dielectric layer 2 has again been annealed in an atmosphere containing hydrogen and, accordingly, comprises hydrogen atoms at nitrogen vacancies.

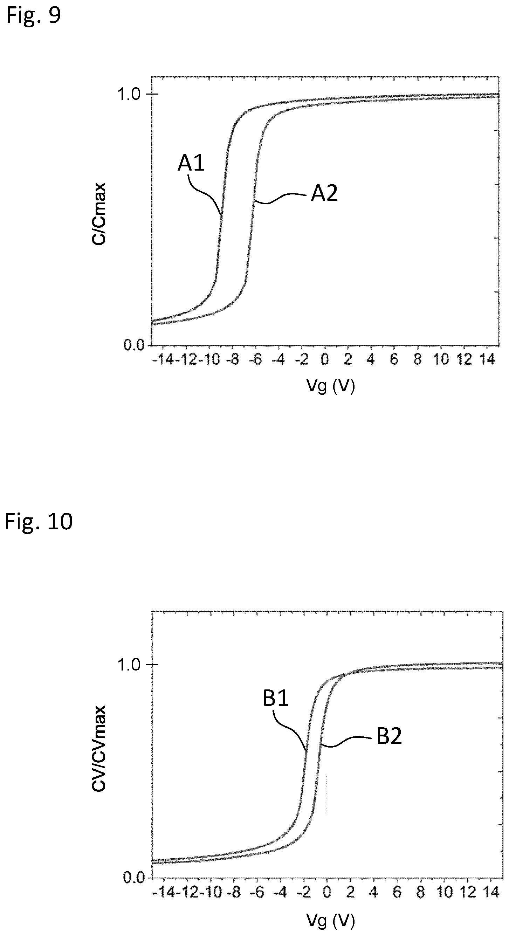

Figures 9 and 10 show measurements of the capacitance voltage characteristics of different dielectric layers applied onto SiC epi wafers. The y-axis shows the relative capacitance C/Cmax and the x-axis shows the applied voltage Vg.

In figure 9, the dielectric layer consists of Si₃N₄. The curve A1 shows the result when the dielectric layer 2 is annealed in a pure nitrogen atmosphere and the curve A2 shows the result when the dielectric layer is annealed in an atmosphere comprising nitrogen and hydrogen, namely about 4 at-% of hydrogen.

In figure 10, a stack of an oxide layer and a nitride-based dielectric layer is applied onto the wafer. Curve B1 shows the result of this stack being annealed in a pure nitrogen atmosphere wherein curve B2 shows the result of the dielectric layer being annealed in an atmosphere comprising nitrogen and hydrogen.

In both figures 9 and 10 it can be seen that the annealing of the nitride-based dielectric layer 2 in a hydrogen containing atmosphere results in a clear shift of V_{FB} towards 0 V.

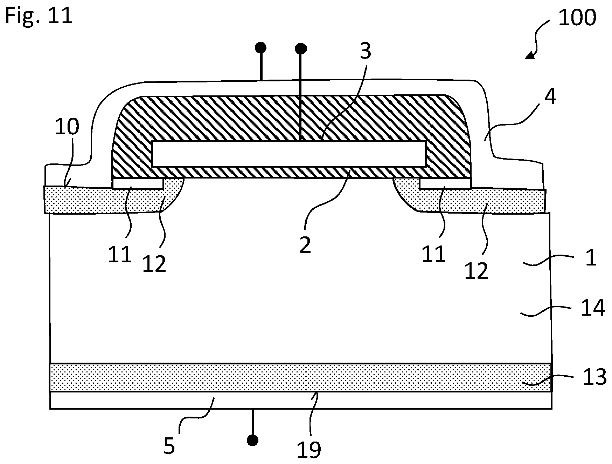

Figure 11 shows a further exemplary embodiment of the semiconductor device 100. It is similar to the one of figure 7. However, in this case, the contact layer 13 is p-doped so that the semiconductor device 100 constitutes an IGBT.

The embodiments shown in the Figures 1 to 8 and 11 as stated represent exemplary embodiments of the method for producing a semiconductor device and the semiconductor device; therefore, they do not constitute a complete list of all embodiments according to the method and the semiconductor device. The present invention is solely defined by the subject-matter of the appended claims.

### Reference Signs

- 1: semiconductor body
- 2: nitride-based dielectric layer
- 3: electrically conductive layer / gate electrode
- 4: first main electrode
- 5: second main electrode
- 6: trench
- 10: top side
- 11: contact region
- 12: base region
- 13: contact layer
- 14: drift region
- 19: bottom side
- 100: semiconductor device

- A1, A2: curves
- B1, B2: curves

## Claims

1. Method for producing a semiconductor device (100) comprising the steps of
- providing a semiconductor body (1) of SiC, having a surface formed of SiC;
- applying a nitride-based dielectric layer (2) of Si₃N₄ and/or Si₂N₂O directly on this surface;
- annealing the nitride-based dielectric layer (2) on the semiconductor body (1), at a temperature of at least 1000 °C for at least 10 minutes, the nitride-based dielectric layer (2) being exposed to an atmosphere which consists of nitrogen and hydrogen at atmospheric pressure ± 20%, wherein a concentration of hydrogen in the atmosphere is at least 1 atomic-% and at most 10 atomic-%.

2. Method according to the preceding claim, wherein
- before applying the nitride-based dielectric layer (2), the surface, which is at least partially formed of SiC, is cleaned.

3. Method according to any one of the preceding claims, further comprising
- applying an electrically conductive layer (3) directly onto the nitride-based dielectric layer (2) after annealing.

4. Method according to claim 3, wherein
- the nitride-based dielectric layer (2) is a gate dielectric and
- the electrically conductive layer (3) is a gate electrode.

5. Method according to any one of the preceding claims, wherein after the step of annealing the nitride-based dielectric layer (2)
- the concentration of hydrogen in the nitride-based dielectric layer (2) is at least 0.1 at-%.

6. Method according to claim 4, wherein
- the finished semiconductor device (100) is a power semiconductor device.

7. Method according to claim 6, wherein
- the semiconductor device (100) is a MOSFET or a MISFET or an IGBT.

8. Method according to any one of the preceding claims, wherein
- the nitride-based dielectric layer is applied with a layer thickness between 20 nm and 200 nm.

9. Method according to any one of the preceding claims, wherein
- during the annealing, nitrogen vacancies are formed in the nitride-based dielectric layer (2), and these nitrogen vacancies are at least partially filled with hydrogen atoms during the annealing.

## Patentansprüche

1. Verfahren zur Herstellung einer Halbleitervorrichtung (100), umfassend die folgenden Schritte:
- Bereitstellen eines Halbleiterbodys (1) aus SiC mit einer Oberfläche, die aus SiC gebildet ist;
- Aufbringen einer nitridbasierten dielektrischen Schicht (2) aus Si₃N₄ und/oder Si₂N₂O direkt auf diese Oberfläche;
- Tempern der nitridbasierten dielektrischen Schicht (2) auf dem Halbleiterbody (1) bei einer Temperatur von mindestens 1000 °C für mindestens 10 Minuten, wobei die nitridbasierte dielektrische Schicht (2) bei einem Atmosphärendruck von ± 20% einer Atmosphäre ausgesetzt wird, die aus Stickstoff und Wasserstoff besteht, wobei eine Wasserstoffkonzentration in der Atmosphäre mindestens 1 Atom-% und höchstens 10 Atom-% beträgt.

2. Verfahren nach dem vorhergehenden Anspruch, wobei
- die Oberfläche, die zumindest teilweise aus SiC gebildet ist, vor dem Aufbringen der nitridbasierten dielektrischen Schicht (2) gereinigt wird.

3. Verfahren nach einem der vorhergehenden Ansprüche, ferner umfassend:
- Aufbringen einer elektrisch leitfähigen Schicht (3) direkt auf die nitridbasierte dielektrische Schicht (2) nach dem Tempern.

4. Verfahren nach Anspruch 3, wobei
- die nitridbasierte dielektrische Schicht (2) ein Gate-Dielektrikum ist und
- die elektrisch leitfähige Schicht (3) eine Gateelektrode ist.

5. Verfahren nach einem der vorhergehenden Ansprüche, wobei nach dem Schritt des Temperns der nitridbasierten dielektrischen Schicht (2)
- die Wasserstoffkonzentration in der nitridbasierten dielektrischen Schicht (2) mindestens 0,1 Atom-% beträgt.

6. Verfahren nach Anspruch 4, wobei
- die fertige Halbleitervorrichtung (100) eine Leistungshalbleitervorrichtung ist.

7. Verfahren nach Anspruch 6, wobei
- die Halbleitervorrichtung (100) ein MOSFET oder ein MISFET oder ein IGBT ist.

8. Verfahren nach einem der vorhergehenden Ansprüche, wobei
- die nitridbasierte dielektrische Schicht mit einer Schichtdicke zwischen 20 nm und 200 nm aufgebracht wird.

9. Verfahren nach einem der vorhergehenden Ansprüche, wobei
- während des Temperns Stickstoffleerstellen in der nitridbasierten dielektrischen Schicht (2) gebildet werden und die Stickstoffleerstellen während des Temperns zumindest teilweise mit Wasserstoffatomen gefüllt werden.

## Revendications

1. Procédé de production d'un dispositif semi-conducteur (100) comprenant les étapes suivantes :
- obtention d'un corps semi-conducteur (1) en SiC, ayant une surface constituée de SiC ;
- application d'une couche diélectrique à base de nitrure (2) en Si₃N₄ et/ou Si₂N₂O directement sur cette surface ;
- recuit de la couche diélectrique à base de nitrure (2) sur le corps semi-conducteur (1), à une température d'au moins 1000 °C pendant au moins 10 minutes, la couche diélectrique à base de nitrure (2) étant exposée à une atmosphère qui consiste en de l'azote et de l'hydrogène à pression atmosphérique ± 20 %, une concentration d'hydrogène dans l'atmosphère étant d'au moins 1 % en atomes et au plus 10 % en atomes.

2. Procédé selon la revendication précédente, dans lequel,
- avant l'application de la couche diélectrique à base de nitrure (2), la surface, qui est au moins partiellement constituée de SiC, est nettoyée.

3. Procédé selon l'une quelconque des revendications précédentes, comprenant en outre
- l'application d'une couche électriquement conductrice (3) directement sur la couche diélectrique à base de nitrure (2) après recuit.

4. Procédé selon la revendication 3, dans lequel
- la couche diélectrique à base de nitrure (2) est un diélectrique de grille et
- la couche électriquement conductrice (3) est une électrode de grille.

5. Procédé selon l'une quelconque des revendications précédentes, dans lequel, après l'étape de recuit de la couche diélectrique à base de nitrure (2),
- la concentration d'hydrogène dans la couche diélectrique à base de nitrure (2) est d'au moins 0,1 % en atomes.

6. Procédé selon la revendication 4, dans lequel
- le dispositif semi-conducteur fini (100) est un dispositif semi-conducteur de puissance.

7. Procédé selon la revendication 6, dans lequel
- le dispositif semi-conducteur (100) est un MOSFET ou un MISFET ou un IGBT.

8. Procédé selon l'une quelconque des revendications précédentes, dans lequel
- la couche diélectrique à base de nitrure est appliquée à une épaisseur de couche comprise entre 20 nm et 200 nm.

9. Procédé selon l'une quelconque des revendications précédentes, dans lequel
- pendant le recuit, des lacunes d'azote se forment dans la couche diélectrique à base de nitrure (2), et ces lacunes d'azote sont au moins partiellement remplies avec des atomes d'hydrogène pendant le recuit.
